# EUROPEAN PATENT SPECIFICATION

(11) **EP 3 624 327 B1**
(45) Date of publication and mention of the grant of the patent: **09.06.2021**
(21) Application number: 18798395.2
(22) Date of filing: 04.04.2018
(51) Int. Cl.: H02N 2/18, H01L 41/047, H01L 41/113

(54) **POWER GENERATION DEVICE AND SENSOR-INCORPORATED BODY USING SAME**
ENERGIEERZEUGUNGSVORRICHTUNG UND DIESELBE VERWENDENDER SENSORINTEGRIERTER KÖRPER
DISPOSITIF DE PRODUCTION D'ÉLECTRICITÉ ET CORPS INTÉGRÉ À UN CAPTEUR UTILISANT LEDIT DISPOSITIF

(30) Priority: 09.05.2017 JP 2017092716
(43) Date of publication of application: 18.03.2020
(73) Proprietor: Panasonic Intellectual Property Management Co., Ltd., Osaka-shi, Osaka 540-6207 (JP)
(72) Inventor: FUKUI, Takafumi, Osaka-shi, Osaka 540-6207 (JP); KONISHI, Toshihiro, Osaka-shi, Osaka 540-6207 (JP); KATSUMURA, Hidenori, Osaka-shi, Osaka 540-6207 (JP); OKUMURA, Hidenori, Osaka-shi, Osaka 540-6207 (JP)
(74) Representative: Grünecker Patent- und Rechtsanwälte PartG mbB
(86) International application number: PCT/JP2018/014483
(87) International publication number: WO 2018/207507

(56) References cited:
- WO-A1-2012/153593
- WO-A1-2014/076895
- JP-A- 2005 270 640
- JP-A- 2005 270 640
- JP-A- 2011 152 004
- JP-A- 2011 160 577
- JP-A- 2016 077 037
- US-A1- 2013 285 507

## Description

### TECHNICAL FIELD

The present disclosure relates to a power generation device that generates alternating current power by vibration.

### BACKGROUND ART

A conventional power generation device includes a housing and a power generation unit. The power generation unit is disposed in the housing. The power generation unit includes a substrate, a power generator, and an electrode. A middle portion of the substrate is held. The substrate has a first end that is away from the held portion in a first direction and a second end that is away from the held portion in a second direction. The first direction is opposite to the second direction. The power generator is formed so as to extend from the first end to the second end. The electrode is formed so as to extend from the first end to the second end and is electrically connected to the power generator.

The conventional power generation device generates power by letting the first end and the second end vibrate and thereby sending vibrations to the power generator. Alternating current power generated at the power generator is drawn by the electrode.

PTL 1 is, for example, known as a prior art containing information related to the invention in this application.

### Citation List

### Patent Literature

PTL 1: Unexamined Japanese Patent Publication No. 2006-158113

US 2013/285507 A1 relates to a vibration power generating element and a vibration power generating device using the vibration power generating element. JP 2011 160577 A relates to a piezoelectric power generator. JP 2005 270640 A relates to a sports implement having a functional circuit.

### SUMMARY OF THE INVENTION

In the conventional power generation device, the electrode is formed so as to extend from the first end to the second end. Thus, in the conventional power generation device, if a difference in phase between a vibration of the first end and a vibration of the second end arises, there occurs interference between alternating current power generated at the first end and alternating current power generated at the second end.

An object of the present invention, which has been accomplished to solve the problem, is to provide a power generation device that restrains interference between a plurality of flows of alternating current power if the flows of alternating current power are generated in the power generation device.

A power generation device according to the present invention is defined in claim 1

The power generation device according to the aspect of the present disclosure is configured such that the first power generator and the second power generator are electrically isolated from each other. Hence, according to the aspect of the present disclosure, the power generation device thus provided is able to restrain interference between alternating current power generated by the first power generator and alternating current power generated by the second power generator. Further advantageous embodiments are defined in dependent claims.

### BRIEF DESCRIPTION OF THE DRAWINGS

FIG. 1 is a schematic cross-sectional view of a power generation device according to the present disclosure, viewed from a side.
FIG. 2 is a schematic cross-sectional view of a sensor-incorporated body according to the present disclosure, viewed from a top.

### DESCRIPTION OF EMBODIMENT

### (First exemplary embodiment)

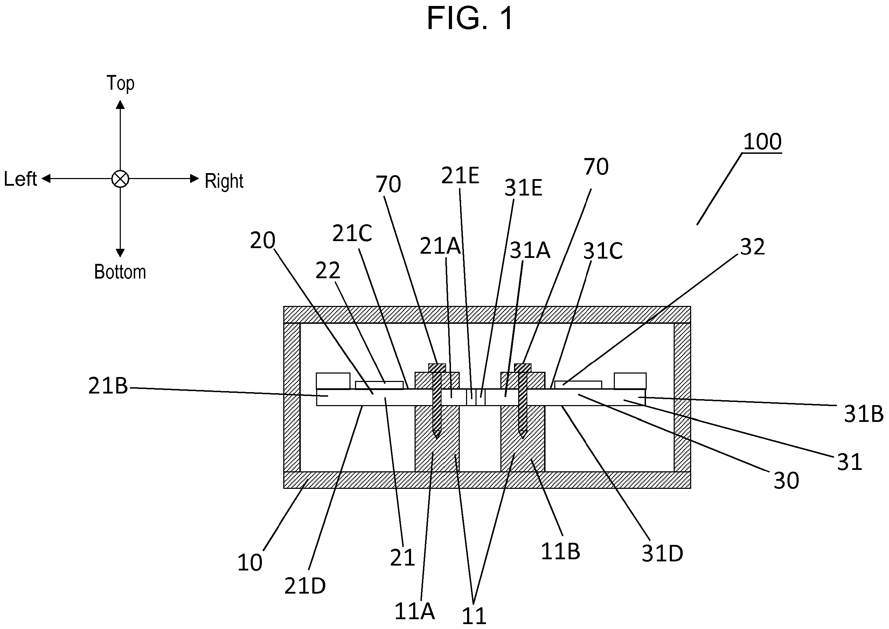

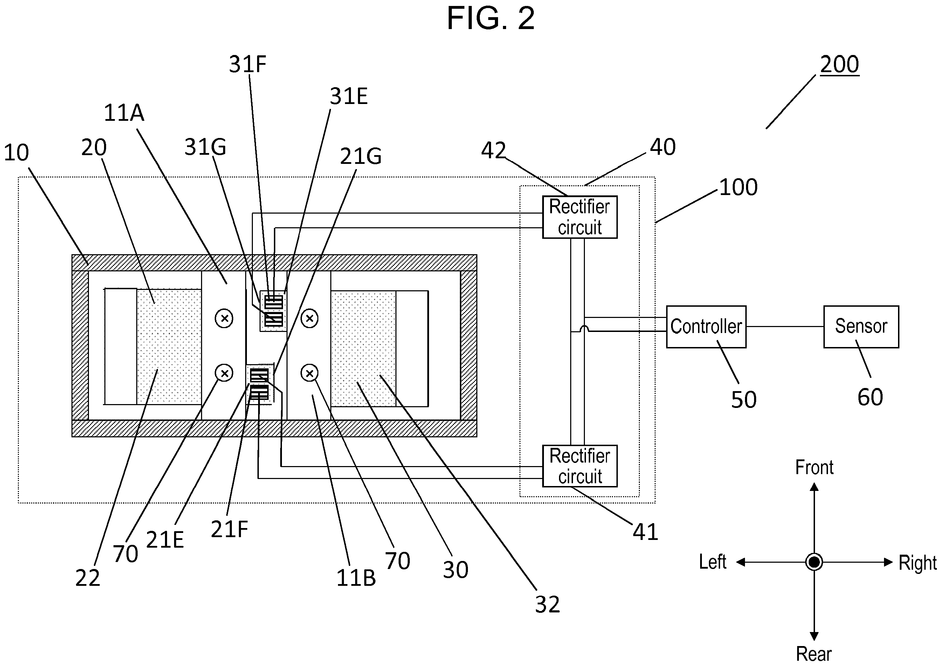

With reference to FIGS. 1 and 2, an outline of power generation device 100 will be described. FIG. 1 is a schematic cross-sectional view of the power generation device, viewed from a side, i.e. a rear side of the power generation device. FIG. 2 is a schematic cross-sectional view of a sensor-incorporated body, viewed from a top.

Power generation device 100 includes housing 10, first power generator 20, and second power generator 30. First power generator 20 is disposed in housing 10. First power generator 20 is held in housing 10 so as to be allowed to vibrate.

Second power generator 30 is disposed in housing 10. Second power generator 30 is held in housing 10 so as to be allowed to vibrate. Second power generator 30 is electrically isolated from first power generator 20.

"Electrically isolated" refers to a state in which alternating current power generated by first power generator 20 and alternating current power generated by second power generator 30 do not mix (combine) with each other. An "electrically isolated" configuration is, for example, a configuration in which an electrode used to draw generated power from first power generator 20 and an electrode used to draw generated power from second power generator 30 are separated from each other, or a configuration in which first power generator 20 and second power generator 30 are electrically insulated from each other. An "electrically isolated" configuration where the first power generator and the second power generator are connected with each other is, for example, a configuration in which alternating current power generated by first power generator 20 and power generated by second power generator 30 are separately rectified and then combined together.

In response to an external force such as an impact, a vibration, sound, or wind, power generation device 100, for example, lets first power generator 20 and second power generator 30 vibrate. First power generator 20 vibrates and thereby generates alternating current power. Second power generator 30 vibrates and thereby generates alternating current power. In other words, first power generator 20 and second power generator 30 separately generate electricity to generate respective flows of alternating current power.

In power generation device 100, first power generator 20 and second power generator 30 are electrically isolated from each other. Hence, alternating current power generated by first power generator 20 does not mix with alternating current power generated by second power generator 30. In other words, alternating current power generated by first power generator 20 does not influence alternating current power generated by second power generator 30. As a result, power generation device 100 is able to restrain interference between alternating current power generated by first power generator 20 and alternating current power generated by second power generator 30.

Power generation device 100 will now be described in more detail.

Power generation device 100 includes housing 10, first power generator 20, and second power generator 30. Housing 10 is electrically isolated from first power generator 20 and second power generator 30. More preferably, housing 10 is made from an insulating material and is electrically insulated.

First power generator 20 includes first substrate 21 and first power generating part 22. First substrate 21 has first fixed end 21A and first free end 21B. First fixed end 21A is fixed to a location near a middle of housing 10 (near a middle of a lengthwise dimension of housing 10 in FIGS. 1 and 2). First free end 21B is disposed at a location that is nearer to an end of housing 10 than to first fixed end 21A. First free end 21B is mechanically joined to first fixed end 21A. Hence, first free end 21B is allowed to vibrate. To simplify description given hereinafter, a direction in which the first substrate extends from first fixed end 21A toward first free end 21B is designated as a first direction and in accordance with FIG. 1, the first direction is referred to as a "left direction".

First substrate 21 has first surface 21C and second surface 21D. First surface 21C is a surface disposed opposite to second surface 21D. For instance, if first surface 21C is a front side, second surface 21D is a back side. For instance, if first surface 21C is a back side, second surface 21D is a front side.

First surface 21C is disposed between first fixed end 21A and first free end 21B. Second surface 21D is disposed between first fixed end 21A and first free end 21B.

First power generating part 22 is formed on first substrate 21. First power generating part 22 may be formed on first surface 21C or second surface 21D. First power generating part 22 may be formed on both first surface 21C and second surface 21D. In other words, first power generating part 22 is satisfactorily formed on first substrate 21 so as to be allowed to generate electricity by a vibration of first substrate 21.

First power generating part 22 is a laminate of electrodes and a piezoelectric layer put between the electrodes. In other words, the first power generating part includes, in the order of smaller distance from the substrate, one of the electrodes formed on the substrate, the piezoelectric layer, and the other electrode formed on the piezoelectric layer.

If the first power generating part is formed on both first surface 21C and second surface 21D, the first power generating part is preferably formed such that a polarity of the piezoelectric layer formed at first surface 21C is opposite to a polarity of the piezoelectric layer formed at second surface 21D.

First power generating part 22, if formed on both first surface 21C and second surface 21D, contributes to an increase in voltage per unit area of first substrate 21.

If the first power generating part is formed on both first surface 21C and second surface 21D, the first power generating part is preferably formed such that a polarity of the piezoelectric layer formed at first surface 21C is opposite to a polarity of the piezoelectric layer formed at second surface 21D. First power generating part 22 formed in this manner restrains alternating current power generated at first surface 21C and alternating current power generated at first surface 21C from interfering with each other.

Second power generator 30 includes second substrate 31 and second power generating part 32. Second substrate 31 and first substrate 21 are formed separately. Second substrate 31 has second fixed end 31A and second free end 31B.

Second fixed end 31A is fixed to a location near the middle of housing 10 (near the middle of the lengthwise dimension of housing 10 in FIGS. 1 and 2). Second free end 31B is disposed at a location that is nearer to an end of housing 10 than to second fixed end 31A. Second free end 31B is mechanically joined to second fixed end 31A. Second free end 31B is allowed to vibrate. A direction in which the second substrate extends from second fixed end 31A toward second free end 31B is opposite to the first direction. To simplify description given hereinafter, the direction in which the second substrate extends from second fixed end 31A toward second free end 31B is designated as a second direction and in accordance with FIG. 1, the second direction is referred to as a "right direction". Second fixed end 31A is disposed so as to be shifted relative to first fixed end 21A in the right direction.

Second substrate 31 has third surface 31C and fourth surface 31D. Third surface 31C is a surface disposed opposite to fourth surface 31D. For instance, if third surface 31C is a front side, fourth surface 31D is a back side. For instance, if third surface 31C is a back side, fourth surface 31D is a front side.

Third surface 31C is disposed between second fixed end 31A and second free end 31B. Fourth surface 31D is disposed between second fixed end 31A and second free end 31B.

Second power generating part 32 is formed on second substrate 31. Second power generating part 32 may be formed on third surface 31C or fourth surface 31D. Second power generating part 32 may be formed on both third surface 31C and fourth surface 31D. In other words, second power generating part 32 is satisfactorily formed on second substrate 31 so as to be allowed to generate electricity by a vibration of second substrate 31.

Second power generating part 32 is a laminate of electrodes and a piezoelectric layer put between the electrodes. In other words, the second power generating part includes, in the order of smaller distance from the substrate, one of the electrodes formed on the substrate, the piezoelectric layer, and the other electrode formed on the piezoelectric layer.

Second power generating part 32, if formed on both third surface 31C and fourth surface 31D, contributes to an increase in voltage per unit area of second substrate 31.

If the second power generating part is formed on both third surface 31C and fourth surface 31D, the second power generating part is preferably formed such that a polarity of the piezoelectric layer formed at third surface 31C is opposite to a polarity of the piezoelectric layer formed at fourth surface 31D. Second power generating part 32 formed in this manner restrains alternating current power generated at third surface 31C and alternating current power generated at fourth surface 31D from interfering with each other.

First power generating part 22 and second power generating part 32 are formed separately, and hence first power generating part 22 and second power generating part 32 are electrically isolated from each other. This restrains alternating current power generated by first power generating part 22 from interfering with alternating current power generated by second power generating part 32.

Power generation device 100 includes first power generator 20 and second power generator 30 disposed in this manner and is hence able to restrain variations in power generation amount even if housing 10 is elongated in the right and left direction. First fixed end 21A and second fixed end 31A are in close proximity to each other. This restrains a lag in timing of the start of vibration between first free end 21B and second free end 31B when a vibration is generated against housing 10 in the first direction, the second direction, or a direction perpendicular to both a direction extending from first surface 21C to second surface 21D and the left direction.

A relationship between first fixed end 21A and second fixed end 31A will be described. To help understanding of description, a "direction in which first substrate 21 extends from first surface 21C to second surface 21D" is referred to as a top and bottom direction". A "direction perpendicular to both the top and bottom direction and the left direction" is referred to as a "transverse direction". The transverse direction is a direction that is perpendicular to the left direction and parallel to the first surface.

First fixed end 21A overlaps second fixed end 31A when viewed along the transverse direction. This allows a length of the housing needed for the disposition of first power generator 20 and second power generator 30 to be shortened in the left direction and the right direction.

A description will be given more specifically. First fixed end 21A includes first protrusion 21E and first electrode 21F. First protrusion 21E projects in the second direction. Hence, first protrusion 21E has first protrusion end 21G in the second direction. First electrode 21F is formed on first protrusion 21E. First electrode 21F is electrically connected to first power generating part 22. In other words, first electrode 21F draws generated alternating current power from first power generating part 22.

Second fixed end 31A includes second protrusion 31E and second electrode 31F. Second protrusion 31E projects in the first direction. Hence, second protrusion 31E has second protrusion end 31G in the first direction. Second protrusion end 31G is located so as to be shifted in the first direction relative to the first protrusion end. Second electrode 31F is formed on second protrusion 31E. Second electrode 31F is electrically connected to second power generating part 32. In other words, second electrode 31F draws generated alternating current power from second power generating part 32.

First electrode 21F and second electrode 31F are electrically isolated from each other. This restrains alternating current power generated by first power generating part 22 from interfering with alternating current power generated by second power generating part 32. Further, first electrode 21F and second electrode 31F are disposed such that a distance between first electrode 21F and second electrode 31F is short. This configuration facilitates the connection of wires used to draw generated alternating current power from first power generating part 22 and generated alternating current power from second power generating part 32. In other words, this configuration restrains wires connected to first electrode 21F or second electrode 31F from hampering the vibration of first substrate 21 and the vibration of second substrate 31.

Housing 10 will be described in more detail. A width of housing 10 is wider in the right and left direction than in the transverse direction. In other words, the width in the transverse direction is narrower than the width in the right and left direction. Housing 10 has fastening unit 11 to fasten first fixed end 21A and second fixed end 31A. First fixed end 21A and second fixed end 31A are fastened to fastening unit 11 with screws 70. First fixed end 21A and second fixed end 31A may be fastened to fastening unit 11 by any means, such as bonding, resin molding, or adhesion, other than the screws. Fastening unit 11 may be integrated with or be separate from housing 10. Preferably, fastening unit 11 is mechanically connected to housing 10.

Fastening unit 11 includes first fastening part 11A and second fastening part 11B. First fastening part 11A is configured to fasten first fixed end 21A. Second fastening part 11B is configured to fasten second fixed end 31A. A gap is provided between first fastening part 11A and second fastening part 11B. The gap is disposed at a midpoint of a line segment joining first free end 21B and second free end 31B in the right and left direction. This stabilizes a position of a center of mass of first power generator 20 and second power generator 30 relative to housing 10.

First protrusion 21E is disposed so as to overlap the gap by projecting from first fastening part 11A in the right direction. Second protrusion 31E is disposed at a place that overlaps the gap by projecting from second fastening part 11B in the left direction.

Power generation device 100 further includes rectifier 40. Rectifier 40 includes first rectifier circuit 41 electrically connected with first power generating part 22 and second rectifier circuit 42 electrically connected with second power generating part 32. First rectifier circuit 41 converts alternating current power generated by first power generating part 22 into direct current power and outputs converted direct current power. Direct current power output from first rectifier circuit 41 may be, for example, a pulsating current. Alternatively, the pulsating current may be smoothed through a capacitor, a coil, or another component. In other words, direct current power output from first rectifier circuit 41 is satisfactory as long as the direct current power does not change direction over time.

Second rectifier circuit 42 converts alternating current power generated by second power generating part 32 into direct current power and outputs converted direct current power. Direct current power output from second rectifier circuit 42 may be, for example, a pulsating current. Alternatively, the pulsating current may be smoothed through a capacitor, a coil, or another component. In other words, direct current power output from second rectifier circuit 42 is satisfactory as long as the direct current power does not change direction over time.

Direct current power output from first rectifier circuit 41 and direct current power output from second rectifier circuit 42 have identical directivity.

Rectifier 40 synthesizes direct current power output from first rectifier circuit 41 and direct current power output from second rectifier circuit 42 to output synthesized direct current power. This configuration enables power generation device 100 to draw electric power while restraining alternating current power generated by first power generator 20 from interfering with alternating current power generated by second power generator 30.

Rectifier 40 may be disposed inside housing 10 or outside housing 10.

Power generation device 100 is configured as described above. In power generation device 100, first fixed end 21A and second fixed end 31A overlap each other in the transverse direction. However, the first fixed end 21A and second fixed end 31A may overlap each other in the top and bottom direction. In this state, an insulator such as air or a resin is preferably disposed between first fixed end 21A and second fixed end 31A to prevent the occurrence of a short circuit between first fixed end 21A and second fixed end 31A, for example. In this state, first fixed end 21A preferably overlaps second fixed end 31A when viewed along the top and bottom direction. This allows a breadth of space occupied by first power generator 20 and second power generator 30 in the right and left direction to be decreased.

### (Sensor-incorporated body 200)

With reference to FIG. 2, sensor-incorporated body 200 will be described. Sensor-incorporated body 200 includes power generation device 100 and a wearable thing. Power generation device 100 is, for example, housed in the wearable thing. The wearable thing is, for example, clothing, headgear, a protector, footwear, gloves, or a bag worn by a person. Power generation device 100 is connected to controller 50 and other components. This configuration allows power generation device 100 to act as sensor 60 that measures an external force applied to the wearable thing. If power generation device 100 acts as sensor 60, the power generation device provides improved sensing accuracy owing to the capability of restraining interference between first power generator 20 and second power generator 30.

The sensor-incorporated body may be configured such that sensor 60 electrically connected to controller 50 is separately provided and that alternating current power generated by first power generator 20 and second power generator 30 is supplied to controller 50 through the rectifier. In other words, power generation device 100 acts as a power source. In this case, sensor 60 is, for example, a pressure sensor, a magneto-strictive sensor, an acceleration sensor, a temperature sensor, or a humidity sensor.

If the wearable thing is, for example, footwear, power generation device 100 may be disposed in a vicinity of a shankpiece of the footwear because a width of the power generation device is narrower in the right and left direction than in the transverse direction.

### INDUSTRIAL APPLICABILITY

A power generation device according to the present disclosure has a function of restraining interference between flows of alternating current power and thus advantageously used as a sensor, a power source, or something similar.

### REFERENCE MARKS IN THE DRAWINGS

10: housing
11: fastening unit
11A: first fastening part
11B: second fastening part
20: first power generator
21: first substrate
21A: first fixed end
21B: first free end
21C: first surface
21D: second surface
21E: first protrusion
21F: first electrode
21G: first protrusion end
22: first power generating part
30: second power generator
31: second substrate
31A: second fixed end
31B: second free end
31C: third surface
31D: fourth surface
31E: second protrusion
31F: second electrode
31G: second protrusion end
32: second power generating part
40: rectifier
41: first rectifier circuit
42: second rectifier circuit
50: controller
60: sensor
70: screw
100: power generation device
200: sensor-incorporated body

## Claims

1. A power generation device (100) comprising:
a housing (10);
a first power generator (20) held in the housing (10) so as to be allowed to vibrate; and
a second power generator (30) held in the housing (10) so as to be allowed to vibrate, the second power generator (30) being electrically isolated from the first power generator (20),
wherein
the first power generator (20) comprises:
a first substrate (21) including a first fixed end (21A) fixed to a location near a middle of the housing (10) and a first free end (21B) disposed at a location that is nearer to an end of the housing (10) than to the first fixed end (21A); and
a first power generating part (22) formed on the first substrate (21),
the second power generator (30) comprises:
a second substrate (31) including a second fixed end (31A) fixed to a location near the middle of the housing (10) and a second free end (31B) disposed at a location that is nearer to an end of the housing (10) than to the second fixed end (31A); and
a second power generating part (32) formed on the second substrate (31),
on condition that a direction the first substrate (21) extends from the first fixed end (21A) toward the first free end (21B) is designated as a first direction and a direction the second substrate (31) extends from the second fixed end (31A) toward the second free end (31B) is designated as a second direction, the first direction and the second direction are opposite to each other, and the second fixed end (31A) is disposed so as to be shifted relative to the first fixed end (21A) in the second direction,
**characterized in that** the first fixed end (21A) comprises:
a first protrusion (21E) including a first protrusion end (21G) and projecting in the second direction; and
a first electrode (21F) formed on the first protrusion (21E), the first electrode (21F) being electrically connected to the first power generating part (22), and
the second fixed end (31A) comprises:
a second protrusion (31E) including a second protrusion end (31G) and projecting in the first direction, the second protrusion end (31G) being located so as to be shifted in the first direction relative to the first protrusion end (21G); and
a second electrode (31F) formed on the second protrusion (31E), the second electrode (31F) being electrically connected to the second power generating part (32).

2. The power generation device according to claim 1, wherein
the first substrate (21) further comprises:
a first surface (21C) disposed between the first fixed end (21A) and the first free end (21B); and
a second surface (21D) that is disposed opposite to the first surface (21C) and between the first fixed end (21A) and the first free end (21B),
the second substrate (31) further comprises:
a third surface (31C) disposed between the second fixed end (31A) and the second free end (31B); and
a fourth surface (31D) that is disposed opposite to the third surface (31C) and between the second fixed end (31A) and the second free end (31B), and
the first fixed end (21A) partly overlaps the second fixed end (31A) when viewed along a third direction perpendicular to both the first direction and a direction the first substrate (21) extends from the first surface (21C) to the second surface (21D).

3. The power generation device according to claim 1, wherein
the first substrate (21) further comprises:
a first surface (21C) disposed between the first fixed end (21A) and the first free end (21B); and
a second surface (21D) that is disposed opposite to the first surface (21C) and between the first fixed end (21A) and the first free end (21B),
the second substrate (31) further comprises:
a third surface (31C) disposed between the second fixed end (31A) and the second free end (31B); and
a fourth surface (31D) that is disposed opposite to the third surface (31C) and between the second fixed end (31A) and the second free end (31B),
the first power generator (20) is formed on both the first surface (21C) and the second surface (21D), and
the second power generator (30) is formed on both the third surface (31C) and the fourth surface (31D).

4. The power generation device according to claim 1, further comprising a rectifier (40) including a first rectifier circuit (41) electrically connected with the first power generating part (22) and a second rectifier circuit (42) electrically connected with the second power generating part (32), the rectifier (40) being configured to synthesize electric power that has passed through the first rectifier circuit (41) and electric power that has passed through the second rectifier circuit (42).

5. The power generation device according to claim 1, wherein the housing (10) comprises a fastening unit (11) to fasten the first fixed end (21A) and the second fixed end (31A).

6. The power generation device according to claim 5, wherein
the fastening unit (11) comprises:
a first fastening part (11A) to fasten the first fixed end (21A); and
a second fastening part (11B) disposed in a manner that a gap is provided between the first fastening part (11A) and the second fastening part (11B), the second fastening part (11B) being configured to fasten the second fixed end (31A), and
a midpoint of a line segment joining the first free end (21B) and the second free end (31B) along the second direction is located in the gap.

7. The power generation device according to claim 1, wherein a width of the housing (10) is wider in the first direction than in a third direction that is perpendicular to the first direction and parallel to the first surface (21C).

8. The power generation device according to claim 1, further comprising an insulating layer between the first fixed end (21A) and the second fixed end (31A) to provide insulation between the first fixed end (21A) and the second fixed end (31A).

9. A sensor-incorporated body (200) comprising:
a wearable thing;
a power generation device (100) according to claim 7, the power generation device (100) being housed in the wearable thing and being configured to output alternating current power in response to an external force applied to the wearable thing; and
a controller (50) electrically connected to the power generation device (100).

10. The sensor-incorporated body according to claim 9, further comprising a rectifier (40) between the controller (50) and the power generation device (100) to convert the alternating current power into direct current power.

11. The sensor-incorporated body according to claim 10, wherein
the wearable thing is a footwear, and
the power generation device (100) is housed in a vicinity of a shankpiece of the footwear.

## Patentansprüche

1. Stromerzeugungsvorrichtung (100), umfassend:
ein Gehäuse (10);
eine erste Stromerzeugungseinrichtung (20), die in dem Gehäuse (10) so gehalten wird, dass sie schwingen kann; sowie
eine zweite Stromerzeugungseinrichtung (30), die in dem Gehäuse (10) so gehalten wird, dass sie schwingen kann, wobei die zweite Stromerzeugungseinrichtung (30) gegenüber der ersten Stromerzeugungseinrichtung (20) elektrisch isoliert ist, und
die erste Stromerzeugungseinrichtung (20) umfasst:
ein erstes Substrat (21), das ein erstes festes Ende (21A), das an einer Position in der Nähe einer Mitte des Gehäuses (10) fixiert ist, und ein erstes freies Ende (21B) enthält, das an einer Position angeordnet ist, die näher an einem Ende des Gehäuses (10) als an dem ersten festen Ende (21A) liegt; sowie
einen ersten Strom erzeugenden Teil (22), der an dem ersten Substrat (21) ausgebildet ist,
die zweite Stromerzeugungseinrichtung (30) umfasst:
ein zweites Substrat (31), das ein zweites festes Ende (31A), das an einer Position in der Nähe einer Mitte des Gehäuses (10) fixiert ist, und ein zweites freies Ende (31B) enthält, das an einer Position angeordnet ist, die näher an einem Ende des Gehäuses (10) als an dem zweiten festen Ende (31A) liegt; sowie
einen zweiten Strom erzeugenden Teil (32), der an dem zweiten Substrat (31) ausgebildet ist,
wobei, unter der Bedingung, dass eine Richtung, in der sich das erste Substrat (21) von dem ersten festen Ende (21A) auf das erste freie Ende (21B) zu erstreckt, als eine erste Richtung bezeichnet wird, und eine Richtung, in der sich das zweite Substrat (31) von dem zweiten festen Ende (31A) auf das zweite freie Ende (31B) zu erstreckt, als eine zweite Richtung bezeichnet wird, die erste Richtung und die zweite Richtung entgegengesetzt zueinander sind, und das zweite feste Ende (31A) so angeordnet ist, dass es relativ zu dem ersten festen Ende (21A) in der zweiten Richtung verschoben ist,
**dadurch gekennzeichnet, dass** das erste feste Ende (21A) umfasst:
einen ersten Vorsprung (21E), der ein erstes Vorsprungs-Ende (21G) enthält und in der zweiten Richtung vorsteht; sowie
eine erste Elektrode (21F), die an dem ersten Vorsprung (21E) ausgebildet ist, wobei die erste Elektrode (21F) elektrisch mit dem ersten Strom erzeugenden Teil (22) verbunden ist, und
das zweite feste Ende (31A) umfasst:
einen zweiten Vorsprung (31E), der ein zweites Vorsprungs-Ende (31G) enthält und in der ersten Richtung vorsteht, wobei das zweite Vorsprungs-Ende (31G) so angeordnet ist, dass es relativ zu dem ersten Vorsprungs-Ende (21G) in der ersten Richtung verschoben ist; sowie
eine zweite Elektrode (31F), die an dem zweiten Vorsprung (31E) ausgebildet ist, wobei die zweite Elektrode (31F) elektrisch mit dem zweiten Strom erzeugenden Teil (32) verbunden ist.

2. Stromerzeugungsvorrichtung nach Anspruch 1, wobei
das erste Substrat (21) des Weiteren umfasst:
eine erste Fläche (21C), die zwischen dem ersten festen Ende (21A) und dem ersten freien Ende (21B) angeordnet ist; sowie
eine zweite Fläche (21D), die der ersten Fläche (21C) gegenüberliegend und zwischen dem ersten festen Ende (21A) und dem ersten freien Ende (21B) angeordnet ist,
das zweite Substrat (31) des Weiteren umfasst:
eine dritte Fläche (31C), die zwischen dem zweiten festen Ende (31A) und dem zweiten freien Ende (31B) angeordnet ist; sowie
eine vierte Fläche (31D), die der dritten Fläche (31C) gegenüberliegend und zwischen dem zweiten festen Ende (31A) und dem zweiten freien Ende (31B) angeordnet ist, und
das erste feste Ende (21A), in einer dritten Richtung gesehen, die senkrecht sowohl zu der ersten Richtung als auch zu einer Richtung ist, in der sich das erste Substrat (21) von der ersten Fläche (21C) zu der zweiten Fläche (21D) erstreckt, das zweite feste Ende (31A) teilweise überlappt.

3. Stromerzeugungsvorrichtung nach Anspruch 1, wobei
das erste Substrat (21) des Weiteren umfasst:
eine erste Fläche (21C), die zwischen dem ersten festen Ende (21A) und dem ersten freien Ende (21B) angeordnet ist; sowie
eine zweite Fläche (21D), die der ersten Fläche (21C) gegenüberliegend und zwischen dem ersten festen Ende (21A) und dem ersten freien Ende (21B) angeordnet ist,
das zweite Substrat (31) des Weiteren umfasst:
eine dritte Fläche (31C), die zwischen dem zweiten festen Ende (31A) und dem zweiten freien Ende (31B) angeordnet ist; sowie
eine vierte Fläche (31D), die der dritten Fläche (31C) gegenüberliegend und zwischen dem zweiten festen Ende (31A) und dem zweiten freien Ende (31B) angeordnet ist,
die erste Stromerzeugungseinrichtung (20) sowohl an der ersten Fläche (21C) als auch an der zweiten Fläche (21D) ausgebildet ist, und
die zweite Stromerzeugungseinrichtung (30) sowohl an der dritten Fläche (31C) als auch an der vierten Fläche (31D) ausgebildet ist.

4. Stromerzeugungsvorrichtung nach Anspruch 1, die des Weiteren einen Gleichrichter (40) umfasst, der eine erste Gleichrichterschaltung (41), die elektrisch mit dem ersten Strom erzeugenden Teil (22) verbunden ist, und eine zweite Gleichrichterschaltung (42) enthält, die elektrisch mit dem zweiten Strom erzeugenden Teil (32) verbunden ist, wobei der Gleichrichter (40) so ausgeführt ist, dass er elektrischen Strom, der die erste Gleichrichterschaltung (41) durchlaufen hat, und elektrischen Strom zusammenführt, der die zweite Gleichrichterschaltung (42) durchlaufen hat.

5. Stromerzeugungsvorrichtung nach Anspruch 1, wobei das Gehäuse (10) eine Befestigungs-Einheit (11) zum Befestigen des ersten festen Endes (21A) und des zweiten festen Endes (31A) umfasst.

6. Stromerzeugungsvorrichtung nach Anspruch 5, wobei
die Befestigungs-Einheit (11) umfasst:
ein erstes Befestigungsteil (11A) zum Befestigen des ersten festen Endes (21A); sowie
ein zweites Befestigungsteil (11B), das so angeordnet ist, dass ein Spalt zwischen dem ersten Befestigungsteil (11A) und dem zweiten Befestigungsteil (11B) vorhanden ist, wobei das zweite Befestigungsteil (11B) zum Befestigen des zweiten festen Endes (31A) ausgeführt ist, und
ein Mittelpunkt einer Geraden, die das erste freie Ende (21B) und das zweite freie Ende (31B) in der zweiten Richtung verbindet, in dem Spalt liegt.

7. Stromerzeugungsvorrichtung nach Anspruch 1, wobei eine Breite des Gehäuses (10) in der ersten Richtung größer ist als in einer dritten Richtung, die senkrecht zu der ersten Richtung und parallel zu der ersten Fläche (21C) ist.

8. Stromerzeugungsvorrichtung nach Anspruch 1, die des Weiteren eine isolierende Schicht zwischen dem ersten festen Ende (21A) und dem zweiten festen Ende (31A) umfasst, die Isolierung zwischen dem ersten festen Ende (21A) und dem zweiten festen Ende (31A) bewirkt.

9. Körper (200) mit integriertem Sensor, der Folgendes umfasst:
ein Wearable;
eine Stromerzeugungsvorrichtung (100) nach Anspruch 7, wobei die Stromerzeugungsvorrichtung (100) in dem Wearable aufgenommen und so ausgeführt ist, dass sie in Reaktion auf eine auf das Wearable von außen ausgeübte Kraft Wechselstrom ausgibt; sowie
eine Steuerungseinrichtung (50), die elektrisch mit der Stromerzeugungsvorrichtung (100) verbunden ist.

10. Körper mit integriertem Sensor nach Anspruch 9, der des Weiteren einen Gleichrichter (40) zwischen der Steuerungseinrichtung (50) und der Stromerzeugungsvorrichtung (100) zum Umwandeln des Wechselstroms in Gleichstrom umfasst.

11. Körper mit integriertem Sensor nach Anspruch 10, wobei
das Wearable eine Fußbekleidung ist, und
die Stromerzeugungsvorrichtung (100) nahe an einem Gelenkstück der Fußbekleidung aufgenommen ist.

## Revendications

1. Dispositif de génération d'énergie (100) comprenant :
un boîtier (10) ;
un premier générateur d'énergie (20) maintenu dans le boîtier (10) de manière à pouvoir vibrer ; et
un deuxième générateur d'énergie (30) maintenu dans le boîtier (10) de manière à pouvoir vibrer, le deuxième générateur d'énergie (30) étant isolé électriquement du premier générateur d'énergie (20),
dans lequel
le premier générateur d'énergie (20) comprend :
un premier substrat (21) comprenant une première extrémité fixe (21A) fixée à un emplacement proche du milieu du boîtier (10) et une première extrémité libre (21B) disposée à un emplacement qui est plus proche d'une extrémité du boîtier (10) que de la première extrémité fixe (21A) ; et
une première partie de génération d'énergie (22) formée sur le premier substrat (21),
dans lequel le deuxième générateur d'énergie (30) comprend :
un deuxième substrat (31) comprenant une deuxième extrémité fixe (31A) fixée à un emplacement proche du milieu du boîtier (10) et une deuxième extrémité libre (31B) disposée à un emplacement qui est plus proche d'une extrémité du boîtier (10) que de la deuxième extrémité fixe (31A) ; et
une deuxième partie de génération d'énergie (32) formée sur le deuxième substrat (31),
à condition qu'une direction du premier substrat (21) qui s'étend depuis la première extrémité fixe (21A) vers la première extrémité libre (21B) soit désignée comme une première direction, et qu'une direction du deuxième substrat (31) qui s'étend depuis la deuxième extrémité fixe (31A) vers la deuxième extrémité libre (31B) soit désignée comme une deuxième direction, la première direction et la deuxième direction étant opposées entre elles, et la deuxième extrémité fixe (31A) étant disposée de manière à être décalée par rapport à la première extrémité fixe (21A) dans la deuxième direction,
**caractérisé en ce que** la première extrémité fixe (21A) comprend :
une première protubérance (21E) qui comporte une première extrémité de protubérance (21G) et qui se projette dans la deuxième direction ; et
une première électrode (21F) formée sur la première protubérance (21E), la première électrode (21F) étant connectée électriquement à la première partie de génération d'énergie (22), et
la deuxième extrémité fixe (31A) comprend :
une deuxième protubérance (31E) qui comporte une deuxième extrémité de protubérance (31G) et qui se projette dans la première direction, la deuxième extrémité de protubérance (31G) étant située de manière à être décalée dans la première direction par rapport à la première extrémité de protubérance (21G) ; et
une deuxième électrode (31F) formée sur la deuxième protubérance (31E), la deuxième électrode (31F) étant connectée électriquement à la deuxième partie de génération d'énergie (32).

2. Dispositif de génération d'énergie selon la revendication 1, dans lequel
le premier substrat (21) comprend en outre :
une première surface (21C) disposée entre la première extrémité fixe (21A) et la première extrémité libre (21B) ; et
une deuxième surface (21D) disposée à l'opposé de la première surface (21C) et entre la première extrémité fixe (21A) et la première extrémité libre (21B),
le deuxième substrat (31) comprend en outre :
une troisième surface (31C) disposée entre la deuxième extrémité fixe (31A) et la deuxième extrémité libre (31B) ; et
une quatrième surface (31D) disposée à l'opposé de la troisième surface (31C) et entre la deuxième extrémité fixe (31A) et la deuxième extrémité libre (31B), et
la première extrémité fixe (21A) chevauche partiellement la deuxième extrémité fixe (31A) vu selon une troisième direction perpendiculaire aussi bien à la première direction qu'à la direction dans laquelle le premier substrat (21) s'étend de la première surface (21C) vers la deuxième surface (21D).

3. Dispositif de génération d'énergie selon la revendication 1, dans lequel
le premier substrat (21) comprend en outre :
une première surface (21C) disposée entre la première extrémité fixe (21A) et la première extrémité libre (21B) ; et
une deuxième surface (21D) disposée à l'opposé de la première surface (21C) et entre la première extrémité fixe (21A) et la première extrémité libre (21B),
le deuxième substrat (31) comprend en outre :
une troisième surface (31C) disposée entre la deuxième extrémité fixe (31A) et la deuxième extrémité libre (31B) ; et
une quatrième surface (31D) disposée à l'opposé de la troisième surface (31C) et entre la deuxième extrémité fixe (31A) et la deuxième extrémité libre (31B),
le premier générateur d'énergie (20) est formé sur aussi bien la première surface (21C) que la deuxième surface (21D), et
le deuxième générateur d'énergie (30) est formé sur aussi bien la troisième surface (31C) que la quatrième surface (31D).

4. Dispositif de génération d'énergie selon la revendication 1, comprenant en outre un redresseur (40) comprenant un premier circuit redresseur (41) connecté électriquement à la première partie de génération d'énergie (22) et un deuxième circuit redresseur (42) connecté électriquement à la deuxième partie de génération d'énergie (32), le redresseur (40) étant configuré pour synthétiser l'énergie électrique qui a traversé le premier circuit redresseur (41) et l'énergie électrique qui a traversé le deuxième circuit redresseur (42).

5. Dispositif de génération d'énergie selon la revendication 1, dans lequel le boîtier (10) comprend une unité d'attache (11) pour attacher la première extrémité fixe (21A) et la deuxième extrémité fixe (31A).

6. Dispositif de génération d'énergie selon la revendication 5, dans lequel l'unité d'attache (11) comprend :
une première partie d'attache (11A) qui s'attache à la première extrémité fixe (21A) ; et
une deuxième partie d'attache (11B) disposée de manière à ce qu'un intervalle soit formé entre la première partie d'attache (11A) et la deuxième partie d'attache (11B), la deuxième partie d'attache (11B) étant configurée pour attacher la deuxième extrémité fixe (31A), et
un point médian d'un segment de ligne qui joint la première extrémité libre (21B) à la deuxième extrémité libre (31B) selon la deuxième direction et se trouve dans l'intervalle.

7. Dispositif de génération d'énergie selon la revendication 1, dans lequel la largeur du boîtier (10) dans la première direction est supérieure à cette largeur dans une troisième direction perpendiculaire à la première direction et parallèle à la première surface (21C).

8. Dispositif de génération d'énergie selon la revendication 1, comprenant en outre une couche d'isolation entre la première extrémité fixe (21A) et la deuxième extrémité fixe (31A) pour fournir une isolation entre la première extrémité fixe (21A) et la deuxième extrémité fixe (31A).

9. Corps incorporant un capteur (200) comprenant :
un objet portable ;
un dispositif de génération d'énergie (100) selon la revendication 7, le dispositif de génération d'énergie (100) étant logé dans l'objet portable et étant configuré pour fournir une alimentation à courant alternatif en réponse à une force externe appliquée à l'objet portable ; et
un contrôleur (50) connecté électriquement au dispositif de génération d'énergie (100).

10. Corps incorporant un capteur selon la revendication 9, comprenant en outre un redresseur (40) entre le contrôleur (50) et le dispositif de génération d'énergie (100) pour convertir l'alimentation à courant alternatif en alimentation à courant continu.

11. Corps incorporant un capteur selon la revendication 10, dans lequel
l'objet portable est une chaussure, et
le dispositif de génération d'énergie (100) est logé à proximité d'un cambrion de la chaussure.
